Europäisches Patentamt

European Patent Office

Office européen des brevets

(19)

(11) Numéro de publication : **0 311 477 B1**

## (12) FASCICULE DE BREVET EUROPEEN

(45) Date de publication du fascicule du brevet :
**13.05.92 Bulletin 92/20**

(51) Int. Cl.⁵ : **G01R 13/30, H03K 5/01, H03G 7/00**

(21) Numéro de dépôt : **88402409.2**

(22) Date de dépôt : **23.09.88**

(54) **Procédé de dilatation d'un signal analogique et dispositif pour la mise en oeuvre du procédé.**

(30) Priorité : **06.10.87 FR 8713784**

(43) Date de publication de la demande :
**12.04.89 Bulletin 89/15**

(45) Mention de la délivrance du brevet :
**13.05.92 Bulletin 92/20**

(84) Etats contractants désignés :
**DE ES GB IT**

(56) Documents cités :
**Néant.**

(73) Titulaire : **SGS-THOMSON
MICROELECTRONICS S.A.
7, Avenue Galliéni
F-94250 Gentilly (FR)**

(72) Inventeur : **Charlet, Pascal
Cabinet Ballot-Schmidt 84 Avenue Kléber
F-75116 Paris (FR)**
Inventeur : **Lauverjat, Eric
Cabinet Ballot-Schmidt 84 Avenue Kléber
F-75116 Paris (FR)**
Inventeur : **Moreno, Rafael
Cabinet Ballot-Schmidt 84 Avenue Kléber
F-75116 Paris (FR)**

(74) Mandataire : **Ballot, Paul Denis Jacques et al
Cabinet Ballot-Schmit, 7, rue le Sueur
F-75116 Paris (FR)**

**Description**

La présente invention concerne un procédé de dilatation d'un signal analogique, plus particulièrement d'au moins une partie d'un signal analogique de forme sensiblement rectangulaire ou carrée. Elle concerne aussi un dispositif pour la mise en oeuvre de ce procédé.

Dans un certain nombre de procédés de fabrication, il est intéressant de pouvoir dilater ou agrandir au moins une partie d'un signal analogique en vue d'utiliser cette partie du signal comme élément de commande du procédé de fabrication. Ainsi, dans la technologie des semiconducteurs, lors de la gravure, on utilise des photomultiplicateurs transformant une intensité lumineuse en un signal électrique analogique qui est ensuite traité par un ordinateur. Or, la partie intéressante du signal analogique en sortie du photomultiplicateur présente une amplitude de quelques millivolts. Il est donc nécessaire de mettre à niveau cette partie de signal pour pouvoir l'utiliser ultérieurement.

Le dispositif actuellement utilisé est constitué d'un amplificateur opérationnel dont le gain et le décalage du zéro sont réalisés par l'intermédiaire de deux potentiomètres. Il s'agit donc d'un système manuel qui demande à être réglé à chaque changement de procédé et à chaque changement de produit.

La présente invention a donc pour but de proposer un procédé de dilatation d'au moins une partie d'un signal analogique de forme sensiblement rectangulaire ou carrée qui effectue automatiquement la mise à niveau du signal analogique.

La présente invention a aussi pour but de proposer un dispositif qui met en oeuvre le procédé de dilatation de la présente invention. Ce dispositif présente l'avantage de contrôler automatiquement le gain et de décaler automatiquement le zéro du signal analogique d'entrée.

En conséquence, la présente invention a pour objet un procédé d'agrandissement d'au moins une partie d'un signal analogique de forme sensiblement rectangulaire ou carrée, caractérisé en ce qu'il consiste à multiplier le signal d'entrée par un signal de programmation fonction du front montant du signal analogique et d'un seuil maximum puis à soustraire un signal de soustraction fonction d'un seuil haut et d'un seuil bas.

Selon une autre caractéristique de la présente invention, le signal de programmation est calculé pour chaque signal analogique, tandis que le signal de soustraction est calculé lors de l'émission d'un signal de remise à zéro puis mémorisé et utilisé pour les signaux analogiques suivants.

Selon un mode de réalisation préférentiel, le signal de programmation est constitué par une rampe qui démarre lors de la détection du front montant du signal analogique et qui s'arrête lorsque le signal de sortie correspond au seuil maximum, la pente de la rampe étant fonction d'un signal-horloge, et le signal de soustraction est constitué par une rampe qui démarre lorsque le signal de sortie correspond à un seuil haut et qui s'arrête lorsque le signal de sortie correspond à un seuil bas, la pente de la rampe étant fonction d'un signal-horloge.

La présente invention a aussi pour objet un dispositif pour la mise en oeuvre du procédé ci-dessus, caractérisé en ce qu'il comporte un amplificateur recevant le signal d'entrée dont le gain est contrôlé par un signal de programmation, des moyens pour générer le signal de programmation en fonction du front montant du signal analogique et d'un seuil maximum, un soustracteur recevant le signal en sortie de l'amplificateur et un signal de soustraction et des moyens pour générer le signal de soustraction en fonction d'un seuil haut et d'un seuil bas.

Selon un mode de réalisation préférentiel du dispositif, les moyens pour générer le signal de programmation comportent un générateur de rampe délivrant le signal de programmation, une première logique de commande contrôlant les différentes opérations de remise à zéro, démarrage, arrêt du générateur de rampe et mémorisation du signal, un dérivateur recevant le signal analogique en entrée et envoyant vers la logique de commande une impulsion de démarrage et un premier comparateur comparant le signal analogique en sortie à un seuil maximum et envoyant vers la logique de commande un signal d'arrêt.

De même, les moyens pour générer le signal de soustraction comportent un générateur de rampe délivrant le signal de soustraction, une deuxième logique de commande contrôlant les différentes opérations de remise à zéro, démarrage, arrêt du générateur de rampe et mémorisation du signal, un deuxième comparateur comparant le signal analogique en sortie à un seuil haut et envoyant à la logique de commande l'impulsion de démarrage et un troisième comparateur comparant le signal analogique en sortie à un seuil bas et envoyant vers la logique de commande un signal d'arrêt.

D'autre part la deuxième logique de commande comporte de plus une remise à zéro démarrant les moyens pour générer le signal de soustraction et des moyens de mémorisation du signal de soustraction obtenue jusqu'à une nouvelle remise à zéro.

De préférence, les générateurs de rampe sont constitués par un compteur numérique connecté à un convertisseur numérique analogique et par une horloge déterminant la pente de la rampe.

Selon une autre caractéristique de la présente invention, le dispositif comporte de plus en entrée un moyen de préamplification et de mise en forme du signal analogique.

D'autres caractéristiques et avantages de la présente invention apparaîtront à la lecture de la description d'un mode de réalisation préférentiel faite ci-après avec référence aux dessins ci-annexés dans lesquels:

   – la figure 1 est un schéma sous forme de bloc d'un dispositif de dilatation d'au moins une partie d'un signal analogique pour la mise en oeuvre du procédé de la présente invention,

   – la figure 2 représente les courbes V = f (t) en entrée et en sortie du dispositif de figure 1,

   – la figure 3 est un schéma d'un mode de réalisation de la première logique de commande utilisée dans le dispositif de figure 1,

   – la figure 4 est un schéma d'un mode de réalisation de la seconde logique de commande utilisée dans le dispositif de figure 1,

   – la figure 5 est un schéma d'une cellule de mémorisation utilisée dans les logiques de commande, et

   – la figure 6 est un schéma d'un mode de réalisation des générateurs de rampe utilisés dans le dispositif de figure 1.

Pour simplifier la description, dans les figures les mêmes éléments portent les mêmes références. D'autre part, dans la présente invention, par signal analogique de forme rectangulaire ou carrée, on entend un signal analogique présentant en particulier un front montant raide, le front descendant pouvant être moins raide.

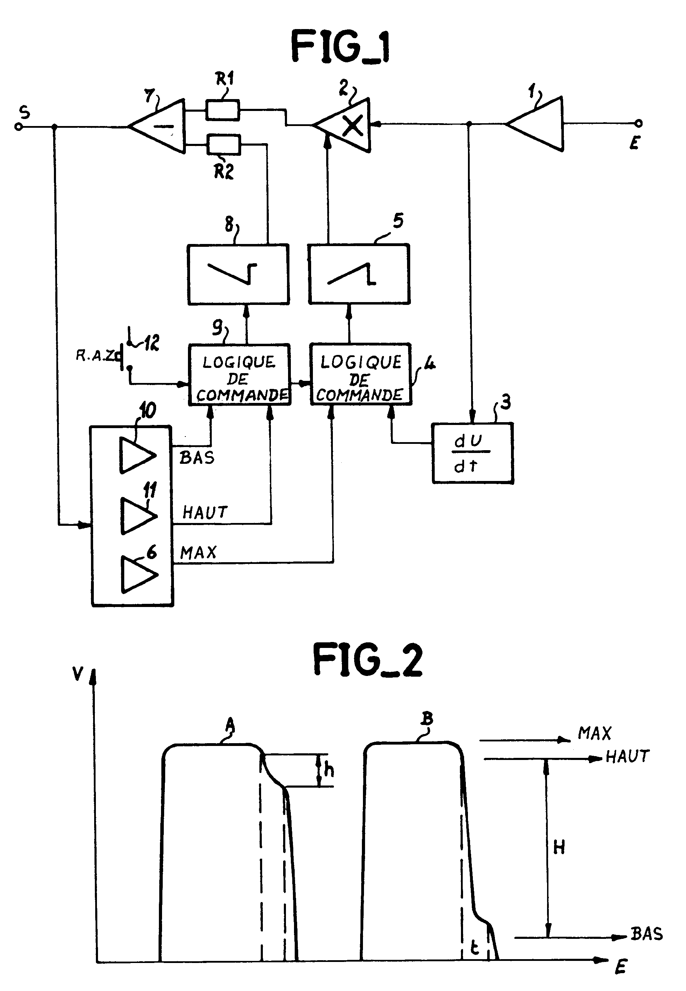

Comme représenté sur la figure 1, le dispositif permettant la mise en oeuvre du procédé de dilatation d'au moins une partie d'un signal analogique de forme sensiblement rectangulaire ou carrée conforme à la présente invention, comporte essentiellement un étage de contrôle automatique de gain et un étage de mise à niveau. L'étage de contôle automatique de gain est constitué d'un amplificateur 2 recevant en entrée le signal analogique E à traiter. De préférence, le signal analogique E a été mis en forme et préamplifié par l'intermédiaire d'un préamplificateur de type connu 1. D'autre part, le signal en sortie du préamplificateur 1 est envoyé sur un dérivateur 3 qui envoit une impulsion de commande vers une logique de commande 4 lors de la détection du front montant d'un signal analogique E. La logique de commande 4 reçoit aussi une impulsion issue d'un comparateur 6 qui compare la sortie S du dispositif à un seuil maximum MAX. La sortie de la logique 4 est envoyée sur un générateur de rampe positive 5 dont la sortie contrôle le gain de l'amplificateur 2. D'autre part, l'étage de mise à niveau comporte essentiellement un soustracteur 7 dont une des entrées est reliée par l'intermédiaire d'une résistance R1 à la sortie de l'amplificateur 2 et dont l'autre entrée est connectée par l'intermédiaire de la résistance R2 à des moyens pour générer le signal de soustraction. Ces moyens sont constitués essentiellement d'un générateur de rampe 8 relié par l'intermédiaire de la résistance R2 au soustracteur et délivrant le signal de soustraction. Ce générateur de rampe est connecté à une logique de commande 9

contrôlant les différentes opérations de remise à zéro, démarrage, arrêt du générateur de rampe et mémorisation du signal. La logique de commande 9 est donc reliée à deux comparateurs 10 et 11 qui lui envoient des signaux de commande. Le comparateur 10 reçoit sur une de ses entrées le signal de sortie S et le compare à un seuil bas fixé tandis que le comparateur 11 reçoit sur une de ses entrées le signal de sortie S et le compare à un seuil haut fixé. D'autre part, la logique de commande 9 est reliée à une remise à zéro 12 envoyant un signal de remise à zéro permettant d'initialiser son fonctionnement. Le signal émis par la remise à zéro 12 est aussi envoyé sur la logique de commande 4.

On expliquera, ci-après, le fonctionnement du dispositif de la figure 1.

Le signal analogique d'entrée E, après mise en forme et préamplification dans le préamplificateur 1, est envoyé sur un dérivateur 3 qui, lorsqu'il détecte le front montant du signal analogique, envoie une impulsion vers la logique 4. Comme expliqué de manière plus détaillée ci-après, la logique 4 est constituée de plusieurs portes logiques qui lorsqu'elles reçoivent une impulsion du dérivateur 3, envoient un signal de démarrage au générateur de rampe 5. Le signal issu du générateur de rampe 5 est envoyé comme signal de programmation du gain sur l'amplificateur 2 qui reçoit en entrée le signal provenant du préamplificateur 1. Ainsi le signal E est amplifié par l'amplificateur 2 dont le gain est programmé par une rampe qui démarre lors de la détection du front montant du signal analogique d'entrée. D'autre part, le signal de sortie S du dispositif est comparé dans le comparateur 16 à un seuil maximum fixé par l'opérateur. Lorsque le signal de sortie S atteint ce seuil maximum, le comparateur 6 envoie une impulsion de commande vers la logique 4. Cette impulsion de commande est transmise vers le générateur de rampe 5 de manière à arrêter la rampe au niveau du seuil fixé. D'autre part, la logique de commande 4 comporte une boucle de mémorisation. En conséquence, une fois que le signal de sortie a atteint le seuil fixé, le signal de programmation est fixé. Le signal peut alors varier mais le gain lui ne variera plus pendant toute la transmission du signal analogique. Cette opération de contrôle automatique du gain est réalisée à chaque fois qu'il y a présence d'un nouveau signal analogique. D'autre part, à chaque fois que l'on appuie sur le bouton de remise à zéro 12 le dispositif de la figure 1 effectue aussi un nouveau décalage de zéro. Pour cela, on soustrait au signal issu de l'amplificateur 2 un signal de soustraction provenant du générateur de rampe 8. Lorsque le signal en sortie S atteint, à la descente, une valeur correspondant au seuil haut, le comparateur 11 envoi un signal vers la logique 9 qui démarre le générateur de rampe 8. Ce générateur de rampe 8 fonctionne jusqu'à ce que le signal en sortie S atteigne une valeur correspondant au seuil bas. A ce moment, le comparateur 10 envoie vers la logique de commande 9 un signal qui arrête le fonctionnement du générateur de rampe 8. Le générateur de rampe 8 génère donc une tension qui est soustraite au signal issu de l'amplificateur 2 dans le soustracteur 7. La valeur de cette tension est en fait mémorisée dans la logique 9 et peut être utilisée pour plusieurs signaux analogiques. Un nouveau calcul de décalage de zéro est effectué à chaque utilisation du bouton de remise à zéro 12.

Ainsi avec le dispositif ci-dessus, si le signal analogique d'entrée E a la forme représentée par la courbe A dans laquelle la partie intéressante est la partie représentée par l'amplitude h et la fraction de temps t, à la sortie du dispositif de la présente invention, on obtient la courbe B agrandie dans des proportions qui sont définies par les valeurs données aux différents seuils. Ainsi, le seuil maximum permet de régler le niveau de la tension en sortie, et les seuils haut et bas permettent de régler l'amplitude H du signal analogique en sortie quelle que soit l'amplitude h, en réalisant un décalage du zéro.

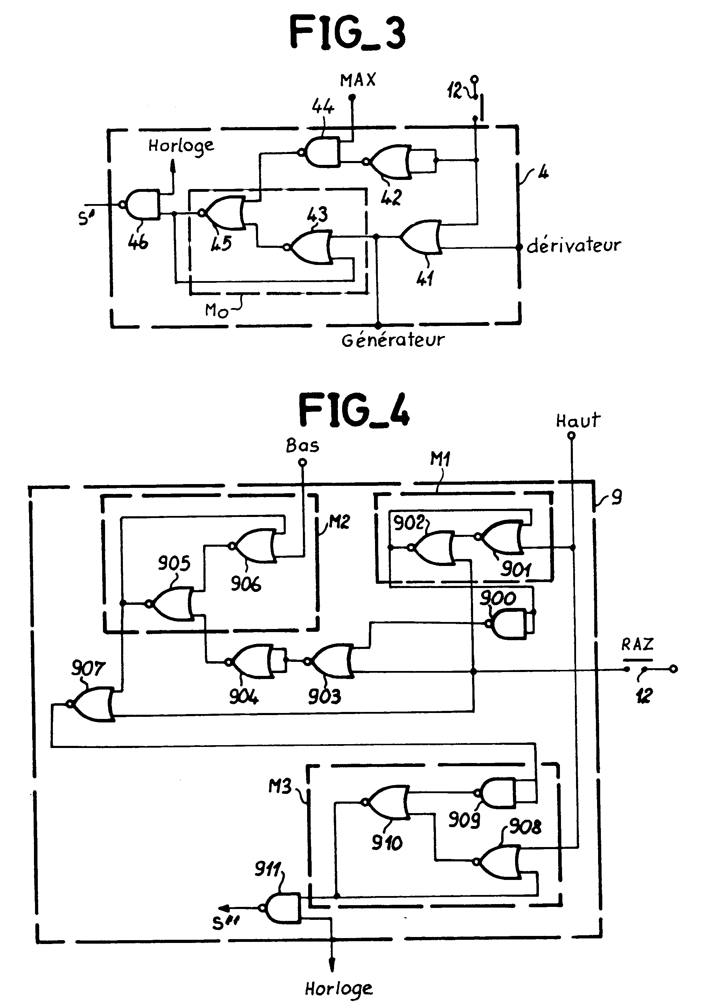

On décrira maintenant avec référence à la figure 3, un mode de réalisation de la logique de commande 4 utilisée pour déterminer le signal de programmation de l'amplificateur à contrôle automatique de gain. La logique 4 est constituée d'une porte OU 41 qui reçoit sur une de ses entrées le signal issu du dérivateur et sur son autre entrée le signal issu de la remise à zéro. La sortie de la porte OU 41 est envoyée sur une porte NI 43 dont l'autre entrée reçoit un signal de rebouclage. La sortie de la porte NI 43 est envoyée sur une porte NI 45. D'autre part, le signal émis par le bouton poussoir RAZ 12 est envoyé sur les deux entrées d'une porte NI 42 dont la sortie est envoyée sur une porte NON-ET 44 dont l'autre entrée reçoit le signal MAX issu du comparateur 6. La sortie de la porte NON-ET 44 est envoyée sur l'autre entrée de la porte NI 45. La sortie de la porte NI 45 est envoyée comme signal de rebouclage sur la deuxième entrée de la porte NI 43. En fait, les deux portes NI 45 et 43 constituent une cellule-mémoire MO et réalisent une fonction de mémorisation comme cela sera expliqué ci-après. D'autre part, la sortie de la porte NI 45 est envoyée sur une porte NON-ET 46 qui reçoit sur son autre entrée un signal d'horloge qui détermine la pente du générateur de rampe 5 comme cela sera expliqué ci-après. Le signal en sortie de la porte NON-ET 46 est envoyé comme commande du générateur de rampe 5.

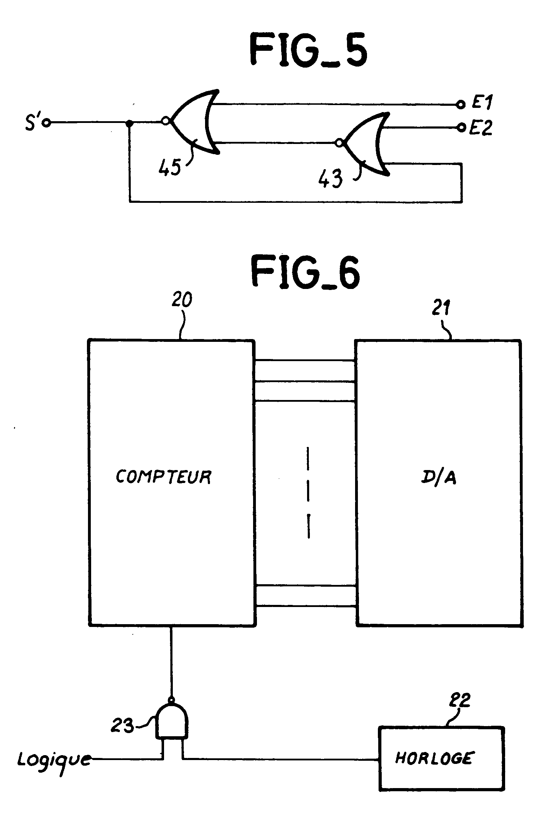

Comme représenté sur la figure 5, la cellule-mémoire MO est réalisée à l'aide de deux portes NI 45 et 43. La porte NI 45 comporte une entrée $E_1$ et reçoit sur son autre entrée la sortie de la porte NI 43. Cette porte comporte une entrée $E_2$ et reçoit sur son autre entrée la sortie de la porte NI 45.

Avec la cellule-mémoire ci-dessus, pour obtenir un niveau logique "1" sur la sortie S', il est nécessaire que l'entrée $E_1$ soit au niveau logique "0" et que l'entrée $E_2$ soit au niveau logique "1". Lorsque la sortie de la porte NI 45 est au niveau logique "1", l'entrée $E_2$ est indifférente. La sortie S' passe au niveau logique "0" lorsque l'entrée $E_1$ passe au niveau "1". Avec ce circuit, l'entrée $E_1$ sert de validation et de remise à zéro et c'est le niveau haut de l'entrée $E_2$ qui est mémorisé.

Ainsi, dans le cas de la figure 3, lorsque le dérivateur passe au niveau logique "1" ou lorsque la RAZ 12 passe au niveau logique "1", la sortie de la porte 41 est positionnée au niveau logique 1. On se trouve donc dans une condition permettant d'armer la cellule-mémoire MO. D'autre part, pour armer la cellule-mémoire MO, la sortie de la porte NON-ET 44 doit être au niveau logique "0". Dans ce cas, l'entrée MAX est au niveau logique "1" et la sortie de la porte NI 42 est aussi au niveau logique "1". Ceci est le cas lorsque la RAZ 12 n'est pas actionnée. Ainsi, tant que le signal MAX est au niveau logique "1" et que la RAZ 12 n'est pas actionnée, la sortie de la porte NI 45 est au niveau logique "1" et autorise le passage des signaux horloge à travers la porte NON-ET 46. Ceci entraîne le fonctionnement du générateur de rampe. Lorsque le signal MAX passe au niveau logique "0" ou lorsque la RAZ 12 est actionée, la sortie de la porte 44 passe au niveau logique "0" entraînant le passage au niveau logique "0" de la sortie de la porte 45 et l'arrêt du générateur de rampe.

On décrira maintenant avec référence à la figure 4, un mode de réalisation de la logique 9 utilisée pour commander le générateur de rampe 8 délivrant le signal de soustraction. Cette logique de commande est constituée essentiellement d'une porte NI 901 recevant sur une de ses entrées le signal issu du comparateur de seuil haut 11. La sortie de la porte NI 901 est connectée sur une entrée d'une porte NI 902 dont l'autre entrée reçoit le signal émis par le bouton poussoir RAZ 12. La sortie de la porte NI 902 est rebouclée sur la deuxième entrée de la porte NI 901 et est connectée sur les deux entrées d'une porte NON-ET 900. La sortie de la porte NON-ET 900 est envoyée sur une porte NI 903 qui reçoit sur son autre entrée le signal émis par le bouton poussoir RAZ 12. La sortie de la porte NI 903 est connectée sur les deux entrées d'une porte NI 904 dont la sortie est connectée une porte NI 905. L'autre entrée de la porte NI 905 reçoit la sortie d'une porte NI 906 qui reçoit sur une de ses entrées le signal émis par le comparateur de seuil bas 10. Le signal de sortie de la porte NI 905 est rebouclé sur la deuxième entrée de la porte NI 906. D'autre part, la sortie de la porte NI 905 est envoyée en entrée d'une porte NI 907 qui reçoit sur son autre entrée le signal émis par le bouton poussoir RAZ 12. La sortie de la porte NI 907 est envoyée sur les deux entrées d'une porte NON-ET 909. La sortie de la porte NON-ET 909 est envoyée sur une entrée d'une porte NI 910 dont l'autre entrée reçoit la sortie d'une porte NI 908. La porte NI 908 reçoit sur une de ses entrées le signal émis par le comparateur de seuil haut et l'autre entrée de la porte NI 908 reçoit le signal de sortie de la porte NI 910 rebouclé. Une porte NON-ET 911 reçoit sur une de ses entrées le signal de sortie de la porte NI 910 et sur son autre entrée un signal horloge. La sortie S″ de la porte NON-ET 911 est envoyée comme signal de commande du générateur de rampe 5. Dans le circuit ci-dessus, les portes NI 901 et 902 constituent une première mémoire M1. La porte NI 906 et la porte NI 905 constituent une second mémoire M2 et les portes NI 910 et 908 constituent une troisième mémoire M3. Ces mémoires sont identiques à la cellule-mémoire MO représentée sur la figure 5 et fonctionnent de manière identique.

Dans ce circuit, le niveau haut du signal référencé haut issu du comparateur de seuil haut est mémorisé dans les mémoires M1 et M3. D'autre part, le niveau haut du signal référencé bas issu du comparateur de seuil bas est mémorisé dans la mémoire M2. La mémoire M1 est validée et remise à zéro par le signal RAZ. La mémoire M2 est validée et remise à zéro par un signal fonction logique du signal RAZ et du signal issu de la mémoire M1, et la mémoire M3 est validée et remise à zéro par un signal fonction logique du signal RAZ et du signal issu de la mémoire M2. Ainsi, lorsque l'on appuie sur le bouton RAZ, les différentes mémoires sont remises à zéro. Puis, lorsque le signal haut passe au niveau logique "1", le signal RAZ étant au niveau logique "0", la sortie de M1 passe au niveau logique "1". La sortie de la porte NON-ET 900 passe au niveau logique "0". La sortie de la porte NI 903 est au niveau logique "1" et la sortie de la porte NI 904 est au niveau logique "0". Le signal bas issu du comparateur de niveau bas est au niveau logique "0" et la sortie de la mémoire M2 reste au niveau logique "0". La sortie de la porte NI 907 est au niveau logique "1" et la sortie de la porte NON-ET 909 est au niveau logique "0". En conséquence, la sortie de la mémoire M1 passe au niveau logique "1" autorisant le fonctionnement du générateur de rampe 8. Lorsque le comparateur de seuil bas détecte le niveau bas, le signal bas passe au niveau logique "1" et la sortie de la mémoire M2 passe alors au niveau logique "1" faisant basculer la sortie de la mémoire M3 au niveau logique "0" ce qui arrête le fonctionnement de l'horloge. Le circuit n'est remis en route que lors d'une nouvelle RAZ.

D'autre part, on décrira maintenant, avec référence à la figure 6, un mode de réalisation d'un générateur de rampe qui peut être utilisé soit comme générateur de rampe 8 ou générateur de rampe 5. Le générateur de rampe utilisé est constitué essentiellement par un compteur 20 dont les sorties sont connectées à un convertisseur numérique-analogique 21. La fréquence de comptage est déterminée par une horloge 22. La sortie de l'horloge 22 est envoyée sur une entrée d'une porte NON-ET 23 dont l'autre entrée reçoit un signal issu d'une logique de commande. La logique de commande peut être constituée soit par la logique 9 représentée en détail à la figure 4 ou la logique 4 présentée en détail à la figure 3.

Le dispositif ci-dessus ainsi que le procédé décrit permet de mettre à l'échelle par l'intermédiaire d'un contrôle de gain et d'un décalage de zéro, tous les signaux analogiques répétitifs pourvu que le signal d'entrée présente un front montant et un front descendant suffisamment raides.

**Revendications**

1. Procédé d'agrandissement d'au moins une partie d'un signal analogique de forme sensiblement rectangulaire ou carrée, caractérisé en ce qu'il consiste à multiplier le signal d'entrée par un signal de programmation fonction du front montant du signal analogique et d'un seuil maximum, puis à soustraire un signal de soustraction fonction d'un seuil haut et d'un seuil bas.

2. Procédé selon la revendication 1, caractérisé en ce que le signal de programmation est calculé pour chaque signal analogique tandis que le signal de soustraction est calculé lors de l'émission d'un signal de remise à zéro puis mémorisé et utilisé pour les signaux analogiques suivants.

3. Procédé selon l'une quelconque des revendications 1 et 2, caractérisé en ce que le signal de programmation est constitué par une rampe qui démarre lors de la détection du front montant du signal analogique et qui s'arrête lorsque le signal de sortie correspond au seuil maximum, la pente de la rampe étant fonction d'un signal-horloge.

4. Procédé selon l'une quelconque des revendications 1 et 2, caractérisé en ce que le signal de soustraction est constitué par une rampe qui démarre lorsque le signal de sortie correspond à un seuil haut et qui s'arrête lorsque le signal de sortie correspond à un seuil bas, la pente de la rampe étant fonction d'un signal-horloge.

5. Dispositif pour la mise en oeuvre du procédé selon l'une quelconque des revendications 1 à 4, caractérisé en ce qu'il comporte un amplificateur (2) recevant le signal d'entrée dont le gain est contrôlé par un signal de programmation, des moyens (3,4,5,6) pour générer le signal de programmation en fonction du front montant du signal analogique et d'un seuil maximum, un soustracteur (7) recevant le signal en sortie de l'amplificateur et un signal de soustraction et des moyens (8,9,10) pour générer le signal de soustraction en fonction d'un seuil haut et d'un seuil bas.

6. Dispositif selon la revendication 5, caractérisé en ce que les moyens pour générer le signal de programmation comportent un générateur de rampe (5) délivrant le signal de programmation, une première logique de commande (4) contrôlant les différentes opérations de remise à zéro, démarrage, arrêt du générateur de rampe et mémorisation du signal, un dérivateur (3) recevant le signal analogique en entrée et envoyant vers la logique de commande une impulsion de démarrage et un premier comparateur (6) comparant le signal analogique en sortie dudit dispositif à un seuil maximum et envoyant vers la logique de commande un signal d'arrêt.

7. Dispositif selon la revendication 5, caractérisé en ce que les moyens pour générer le signal de soustraction comportent un générateur de rampe (8) délivrant le signal de soustraction, une deuxième logique de commande (9) contrôlant les différentes opérations de remise à zéro, démarrage, arrêt du générateur de rampe et mémorisation du signal, un deuxième comparateur (11) comparant le signal analogique en sortie dudit dispositif à un seuil haut et envoyant vers la logique de commande une impulsion de démarrage et un troisième comparateur (10) comparant le signal analogique en sortie dudit dispositif à un seuil bas et envoyant vers la logique de commande un signal d'arrêt.

8. Dispositif selon la revendication 7, caractérisé en ce que la deuxième logique de commande (9) comporte de plus une remise à zéro démarrant les moyens pour générer le signal de soustraction et des moyens de mémorisation du signal de soustraction obtenu jusqu'à une nouvelle remise à zéro.

9. Dispositif selon l'une quelconque des revendications 6 et 7, caractérisé en ce que le générateur de rampe est constitué par un compteur numérique (20) connecté à un convertisseur numérique analogique (21) et par une horloge (22) déterminant la pente de la rampe.

10. Dispositif selon l'une quelconque des revendications 5 à 9, caractérisé en ce qu'il comporte en entrée un moyen de pré-amplification et de mise en forme du signal analogique.

**Patentansprüche**

1. Verfahren zur Vergrößerung wenigstens eines Teils eines Analogsignals, das im wesentlichen eine rechteckige oder quadratische Form besitzt, dadurch gekennzeichnet, daß es die Multiplikation des Eingangssignals mit einem Programmierungssignal, das von der Anstiegsflanke des Analogsignals und von einem maximalen Schwellenwert abhängt, und dann die Subtraktion eines Subtraktionssignals, das von einem hohen Schwellenwert und von einem niedrigen Schwellenwert abhängt, umfaßt.

2. Verfahren gemäß Anspruch 1, dadurch gekennzeichnet, daß das Programmierungssignal für jedes Analogsignal berechnet wird, während das Subtraktionssignal beim Aussenden eines Signals zum Rücksetzen auf Null berechnet, dann gespeichert und für die folgenden Analogsignale verwendet wird.

3. Verfahren gemäß einem der Ansprüche 1 und 2, dadurch gekennzeichnet, daß das Programmierungssignal von einem Rampensignal gebildet wird, dessen Anstieg bei der Erfassung der ansteigenden Flanke des Analogsignals beginnt und dann endet, wenn das Ausgangssignal dem maximalen Schwellenwert entspricht, wobei die Steigung des Rampensignals von einem Taktsignal abhängt.

4. Verfahren gemäß einem der Ansprüche 1 und 2, dadurch gekennzeichnet, daß das Subtraktionssignal von einem Rampensignal gebildet wird, dessen Anstieg beginnt, wenn das Ausgangssignal einem hohen Schwellenwert entspricht, und dessen Anstieg endet, wenn das Ausgangssignal einem niedrigen Schwellenwert entspricht, wobei die Steigung des Rampensignals von einem Taktsignal abhängt.

5. Einrichtung für die Ausführung des Verfahrens gemäß einem der Ansprüche 1 bis 4, dadurch gekennzeichnet, daß sie versehen ist mit einem das Eingangssignal empfangenden Verstärker (2), dessen Verstärkung mittels eines Programmierungssignals gesteuert wird, Mitteln (3, 4, 5, 6) zum Erzeugen des Programmierungssignals in Abhängigkeit von der ansteigenden Flanke des Analogsignals und von einem maximalen Schwellenwert, einem das am Ausgang des Verstärkers anliegende Signal und ein Subtraktionssignal empfangenden Subtrahierer (7) und Mitteln (8, 9, 10) zum Erzeugen des Subtraktionssignals in Abhängigkeit von einem hohen Schwellenwert und von einem niedrigen Schwellenwert.

6. Einrichtung gemäß Anspruch 5, dadurch gekennzeichnet, daß die Mittel zum Erzeugen des Programmierungssignals versehen sind mit einem Rampensignalgenerator (5), der das Programmierungssignal liefert, einer ersten Steuerlogik (4), die die verschiedenen Operationen des Rücksetzens auf Null, des Startens und des Anhaltens des Rampensignalgenerators und des Speicherns des Signals steuert, einer Differenzierschaltung (3), die das Analogsignal an ihrem Eingang empfängt und an die Steuerlogik einen Startimpuls schickt, und einem ersten Komparator (6), der das Analogsignal am Ausgang der Einrichtung mit einem maximalen Schwellenwert vergleicht und an die Steuerlogik ein Stoppsignal schickt.

7. Einrichtung gemäß Anspruch 5, dadurch gekennzeichnet, daß die Mittel zum Erzeugen des Subtraktionssignals versehen sind mit einem Rampensignalgenerator (8), der das Subtraktionssignal liefert, einer zweiten Steuerlogik (9), die die verschiedenen Operationen des Rücksetzens auf Null, des Startens und Anhaltens des Rampensignalgenerators und des Speicherns des Signals steuert, einem zweiten komparator (11), der das Analogsignal am Ausgang der Einrichtung mit einem hohen Schwellenwert vergleicht und an die Steuerlogik einen Startimpuls schickt, und einem dritten komparator (10), der das Analogsignal am Ausgang der Einrichtung mit einem niedrigen Schwellenwert vergleicht und an die Steuerlogik ein Stoppsignal schickt.

8. Einrichtung gemäß Anspruch 7, dadurch gekennzeichnet, daß die zweite Steuerlogik (9) außerdem eine Rückstellung auf Null, die die Mittel zum Erzeugen des Subtraktionssignals startet, und Mittel zum Speichern des Subtraktionssignals, das bis zu einer erneuten Rückstellung auf Null erhalten wird, umfaßt.

9. Einrichtung gemäß einem der Ansprüche 6 und 7, dadurch gekennzeichnet, daß der Rampensignalgenerator einen mit einem Digital-/Analog-Umsetzer (21) verbundenen Digitalzähler (20) und einen die Steigung des Rampensignals bestimmenden Taktgeber (22) umfaßt.

10. Einrichtung gemäß einem der Ansprüche 5 bis 9, dadurch gekennzeichnet, daß sie am Eingang ein Mittel für die Vorverstärkung und für die Formgebung des Analogsignals umfaßt.

## Claims

1. A method for increasing the size of at least part of an analog signal having a substantially rectangular or square form, characterized in that it consists of multiplying the input signal by a programming signal which is a function of the rise flank of the analog signal and of a maximum threshold, then subtracting a subtraction signal which is a function of a high threshold and of a low threshold.

2. The method as claimed in claim 1, characterized in that the programming signal is calculated for each analog signal while the subtraction is performed at the time of creation of a reset to zero signal, then stored and utilized for the following analog signals.

3. The method as claimed in claim 1 or in claim 2, characterized in that the programming signal is constituted by a ramp which starts at the time of the detection of the rise flank of the analog signal and which comes to an end when the output signal corresponds to the maximum threshold, the slope of the ramp being a function of a clock signal.

4. The method as claimed in claim 1 or in claim 2, characterized in that the subtraction signal is constituted by a ramp which starts when the output signal corresponds to a high threshold and which comes to an end when the output signal corresponds to the low threshold, the slope of the ramp being a function of a clock signal.

5. An apparatus for performing the method as claimed in any one of the preceding claims 1 through 4, characterized in that it comprises an amplifier (2) receiving the input signal, whose gain is controlled by a programming signal, means (3, 4, 5 and 6) in order to generate the programming signal as a function of the rise flank of the analog signal and of a maximum threshold, a subtracter (7) receiving the signal at the output of the amplifier and a subtraction signal and means (8, 9 and 10) in order to generate the subtraction signal as a function of a high threshold and of a low threshold.

6. The apparatus as claimed in claim 5, characterized in that the means for generating the programming signal comprise a ramp generator (5) supplying a programming signal, a first logic command means (4) controlling the different operations: reset to zero, starting, halting the ramp generator and storing the signal, a deriving means (3) receiving the input analog signal and sending a start pulse to the command logic means and a first comparator (6) comparing the output analog signal of the said device at a maximum threshold and sending the command logic means a halt signal.

7. The apparatus as claimed in claim 5, characterized in that the means for generating the subtraction signal comprise a ramp generator (8) supplying the subtraction signal, a second command logic means (9) controlling the different operations: reset to zero, starting and halting the ramp generator and storing the signal, a second comparator (11) comparing the output analog signal of the said apparatus at a high threshold and sending the command logic means a start pulse and a third comparator (10) comparing the analog output signal of the apparatus at a low threshold and sending the command logic means a halt signal.

8. The apparatus as claimed in claim 7, characterized in that the second command logic means (9) furthermore comprises a reset to zero means, starting the means for generating the subtraction signal and memory means for storing the subtraction signal obtained until there is a further reset to zero.

9. The apparatus as claimed in claim 6 or claim 7, characterized in that the ramp generator is constituted by a digital analog counter (20) connected with a digital converter (21) and by a clock (22) predetermining the slope of the ramp.

10. The apparatus as claimed in any one of the claims 5 through 9, characterized in that at the input it comprises a means for preamplifying and for shaping the analog signal.

# FIG_1

# FIG_2

# FIG_3

MAX

12

Horloge

44

42

4

S'

46

45

43

41

dérivateur

Mo

Générateur

# FIG_4

Bas

Haut

M1

M2

9

902

905

906

901

900

RAZ

907

904

903

12

M3

910

909

908

911

S"

Horloge

EP 0 311 477 B1

# FIG_5

S'○━━━━━━ 45 ▷○━━━━━ E1
          43 ▷○━━ E2

45

43

# FIG_6

20

21

COMPTEUR

D/A

23

Logique

HORLOGE

22

10